(19) Europäisches Patentamt
European Patent Office
Office européen des brevets

(11) EP 2 262 107 B1

(12) **EUROPEAN PATENT SPECIFICATION**

(45) Date of publication and mention of the grant of the patent:
**12.09.2012 Bulletin 2012/37**

(51) Int Cl.:
***H03F 1/02*** *(2006.01)* ***H03F 1/56*** *(2006.01)*
***H03F 3/60*** *(2006.01)* ***H03F 3/217*** *(2006.01)*
***H01P 1/212*** *(2006.01)*

(21) Application number: **09360033.6**

(22) Date of filing: **10.06.2009**

(54) **Inverse class F amplifier and method**

Verstärker im Inversen F-Betrieb und Verfahren

Amplificateur de classe F inverse et procédé

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**15.12.2010 Bulletin 2010/50**

(73) Proprietor: **Alcatel Lucent**
**75007 Paris (FR)**

(72) Inventor: **Grebennikov, Andrei**
**Castleknock**
**Dublin 15 (IE)**

(74) Representative: **Leppard, Andrew John et al**
**Script IP Limited**
**Turnpike House**
**18 Bridge Street**
**Frome BA11 1BB (GB)**

(56) References cited:
**EP-A- 2 058 943** **US-A1- 2008 191 801**
**US-B1- 7 042 233**

- **GOTO S ET AL: "Efficiency enhancement of doherty amplifier with combination of class-F and inverse class-F schemes for S-band base station application" MICROWAVE SYMPOSIUM DIGEST, 2004 IEEE MTT-S INTERNATIONAL FORT WORTH, TX, USA JUNE 6-11, 2004, PISCATAWAY, NJ, USA,IEEE, vol. 2, 6 June 2004 (2004-06-06), pages 839-842, XP010728250 ISBN: 978-0-7803-8331-9**
- **ALEXANDRE DUPUY ET AL: "Inverse Class-F Power Amplifier Using Composite Right/Left-Handed Transmission Lines as a Harmonic Trap" MICROWAVE CONFERENCE, 2006. 36TH EUROPEAN, IEEE, PI, 1 September 2006 (2006-09-01), pages 360-363, XP031005575 ISBN: 978-2-9600551-6-0**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 262 107 B1

## Description

FIELD OF THE INVENTION.

The present invention relates to an inverse class F amplifier and a method.

BACKGROUND

Inverse class F amplifiers are known. In a wireless telecommunications system, it is often required that power amplifiers are provided which can operate with high efficiency, high linearity and low harmonic levels simultaneously. A switching-mode inverse class F amplifier is a particularly efficient power amplifier, with low harmonic levels at its output.

However, this kind of power amplifier operates in a saturation mode resulting in poor linearity and so is not always suitable to directly replace many linear power amplifiers in conventional wide band code division multiple access (WCDMA) transmitters with non-constant envelope signals. However, in advanced transmitter architectures, it is possible to utilise non-linear high-efficiency power amplifiers operating in an inverse class F mode to obtain high efficiency. Such inverse class F amplifiers seek to prevent transmission of any even harmonics of the input signal. Although many implementations of such inverse class F power amplifiers exist, they each have undesirable characteristics which reduce their operating efficiency and increase the harmonic levels present at their outputs.

GOTO S ET AL: "Efficiency enhancement of doherty amplifier with combination of class-F and inverse class-F schemes for S-band base station application" MICROWAVE SYMPOSIUM DIGEST 2004, IEEE MTT-S INTERNATIONAL FORT WORTH, TX, USA, JUNE 6-11, 2004, PISCATAWAY, NJ, USA, IEEE vol. 2, 6 June 2004, pages 839-842, ISBN 978-0-7803-8331-9 discloses a Doherty amplifier with a combination of class-F and inverse class-F schemes for S-band base station applications. Harmonic resonators for realising the class-F and inverse class-F operation are added in the input and output matching circuit on a high dielectric substrate. These resonators employ open and short stub structures, and control the source and load impedances by adjusting the electric length from the FET terminal. A stub is provided which has an open-circuit effective electrical length of λ/8. Another inverse class F amplifier of the prior art is provided by document US-A-2008/191801.

Accordingly, it is desired to provide an improved inverse class F amplifier.

Summary

According to a first aspect, there is provided an inverse class F amplifier as claimed in Claim 1.

The first aspect recognises that a problem with existing inverse class F amplifiers is that the load network coupled to the amplifying device, such as for example a transistor, does not take account of any output parasitic series bond wire and lead inductance of the amplifying device, which makes it difficult to provide a good second-harmonic peaking and third-harmonic short termination in a real circuit which can dramatically reduce efficiency. Even it if is possible to place the load network close to the amplifying device, the open circuit condition will fully depend on the physical length of the bond wire and lead of the amplifying device, which is difficult to set very accurately in real hybrid or monolithic integrated circuits. Hence, the efficiency of the amplifier can vary enormously, both from design implementation to design implementation and from amplifier to amplifier, depending on variation in the characteristics of the components making up the amplifier.

Accordingly, an amplifier may be provided having an input which receives a signal at a microwave frequency to be amplified and outputs the amplified signal via an output to a load. Between the input and output may be provided a network which may have an amplifying device which amplifies the microwave frequency signal and may have a load network which may have at least one variable length transmission line whose length is adjustable to enable the effective electrical length of that transmission line to be changed. In this way, it is possible to effectively "tune" the amplifier to achieve the desired impedances at the different harmonics and to compensate for the effects of any output parasitic series bond wire and lead inductance of the amplifying device, and any output capacitance. Hence, the characteristics of the amplifier may be adjusted from design implementation to design implementation and/or from amplifier to amplifier to maximise its efficiency.

The load network comprises at least two variable length transmission lines coupling the input with the output, the at least two variable length transmission lines together providing the first, second and third impedances. Hence, a combination of two or more variable length transmission lines may be provided which together may be utilised to provide the required impedances at the different harmonics to maximise the efficiency of the amplifier.

In one embodiment, the at least two variable length transmission lines are provided in series between the input and the output. Hence, the transmission lines may be provided between the input and the output. Typically, the transmission lines will be provided on the output side of the amplifying device, between that amplifying device and the load.

The load network comprises at least a first transmission line, the at least two variable length transmission lines and the first transmission line together providing the first, second and third impedances. Hence, the combination of the variable length transmission lines and the first transmission line stub may together be utilised to provide the required impedances at the different harmonics to maximise the efficiency of the amplifier.

The load network comprises at least a second transmission line, the at least two variable length transmission lines and the first and second transmission lines together providing the first, second and third impedances. Accordingly, a further transmission line stub may be utilised which in combination with the variable length transmission lines and the first transmission line stub may together be utilised to provide the required impedances at the different harmonics to maximise the efficiency of the amplifier.

One of the first and second transmission lines is provided between the two variable length transmission lines and another of the first and second transmission lines is provided between the two variable length transmission lines and the load. Hence, one stub coupled between the two variable length transmission lines, this stub effectively presenting an open-circuit at the fundamental frequency, a short-circuit at the second harmonic frequency and an open-circuit at the third harmonic frequency. The other stub coupled between the two variable length transmission lines and the load and effectively provides assists with impedance matching of the load network and the load at the fundamental frequency, an open-circuit at the second harmonic frequency and a short-circuit at the third harmonic frequency.

The one of the first and second transmission line stub provided between the two variable length transmission lines has an electrical length at the fundamental frequency of around 90° and the another of the first and second transmission lines provided between the two variable length transmission lines and the load has on electrical length at the fundamental frequency of around 30°.

The one of the first and second transmission lines provided between the two variable length transmission lines is arranged in a closed-circuit configuration.

In one embodiment, the another of the first and second transmission lines provided between the two variable length transmission lines and the load is arranged in an open-circuit configuration.

The at least two variable length transmission lines comprise a first variable length transmission line and a second variable length transmission line, the first variable length transmission line being coupled with the input and the second variable length transmission line and the second variable length transmission line being coupled with the first variable length transmission line and the output, the first variable length transmission having an adjustable length to provide a first effective electrical length calculated in accordance with the following equation:

$$\theta_1 = \frac{1}{2}\tan^{-1}\frac{1-(2\omega_0)^2 L_{out} C_{out}}{2 Z_1 \omega_0 C_{out}}$$

and the second variable length transmission having an adjustable length to provide a second effective electrical length calculated in accordance with the following equation:

$$\theta_2 = \frac{\pi}{3} - \frac{1}{3}\tan^{-1}\frac{3\omega_0 L_{out}}{Z_1} - \theta_1$$

where $\theta_1$ and $\theta_2$ are the first and second effective electrical lengths respectively, $\omega_0$ is the fundamental frequency, $L_{out}$ is an output inductance of the amplifying device, $C_{out}$ is an output capacitance of the amplifying device and $Z_1$ is a characteristic impedance of the first and second variable length transmission lines. Accordingly, the exact effective electrical length of the two transmission lines may be determined and the length of these transmission lines adjusted to the calculated length in order to provide an amplifier with the required characteristics to maximise the efficiency of the amplifier.

In one embodiment, when the output inductance of the amplifying device and the output capacitance of the amplifying device are around zero, the first effective electrical length comprises around 45° and the second effective electrical length comprises around 15°.

In one embodiment, the first impedance matches an impedance of the load at the fundamental frequency. Typically, the impedance matching is achieved through the combination of the two variable length transmission lines and the open-circuit stub between these and the load at the fundamental frequency.

In one embodiment, the second impedance is effectively infinite, presenting an open-circuit to the amplifying device at the second harmonic frequency. This is achieved through the combination of one the two variable length transmission lines and the open-circuit stub between these presenting an infinite impedance at the second harmonic frequency, together with the output inductance and the output capacitance of the amplifying device, by creating a parallel resonant circuit.

In one embodiment, the third impedance is effectively zero, presenting a closed circuit to the amplifying device at the third harmonic frequency. This is achieved through the open-circuit stub between the two variable length transmission lines presenting an infinite impedance, and the combination of the two variable length transmission lines and the open-circuit stub between these and the load presenting an zero impedance at the third harmonic frequency, together with the output inductance of the amplifying device, by creating a series resonant circuit.

According to a second aspect, there is provided a method of calibrating an inverse class F amplifier as claimed in Claim 10.

The load network comprises at least two variable length transmission lines coupling the input with the output and the step of adjusting comprises: adjusting a length of the at least two variable length transmission lines to provide the first, second and third impedances.

The at least two variable length transmission lines comprise a first variable length transmission line and a second variable length transmission line, the first variable length transmission line being coupled with the input and the second variable length transmission line and the second variable length transmission line being coupled with the first variable length transmission line and the output, and the step of adjusting comprises: adjusting a length of the first variable length transmission to provide a first effective electrical length calculated in accordance with the following equation:

$$\theta_1 = \frac{1}{2}\tan^{-1}\frac{1-(2\omega_0)^2 L_{out}C_{out}}{2Z_1\omega_0 C_{out}}$$

and adjusting a length of the second variable length transmission to provide a second effective electrical length calculated in accordance with the following equation:

$$\theta_2 = \frac{\pi}{3} - \frac{1}{3}\tan^{-1}\frac{3\omega_0 L_{out}}{Z_1} - \theta_1$$

where $\theta_1$ and $\theta_2$ are the first and second effective electrical lengths respectively, $\omega_0$ is the fundamental frequency, $L_{out}$ is an output inductance of the amplifying device, $C_{out}$ is an output capacitance of the amplifying device and $Z_1$ is a characteristic impedance of the first and second variable length transmission lines.

In one embodiment, when the output inductance of the amplifying device and the output capacitance of the amplifying device are around zero, the step of adjusting comprises: adjusting the first effective electrical length to around 45° and the second effective electrical length to around 15°.

Further particular and preferred aspects are set out in the accompanying independent and dependent claims. Features of the dependent claims may be combined with features of the independent claims as appropriate, and in combinations other than those explicitly set out in the claims.

BRIEF DESCRIPTION OF THE DRAWINGS

Embodiments of the present invention will now be described further, with reference to the accompanying drawings, in which:

Figures 1A and 1B illustrate schematically an arrangement of an inverse class F amplifier according to one embodiment;

Figures 2A to 2C show the effective circuit presented to the amplifying device at the fundamental, second and third harmonic frequencies;

Figure 3A and 3B illustrate the impedance characteristics of transmission lines of differing electrical lengths in both open-circuit and a closed-circuit arrangements; and

Figure 4 is a graph illustrates varying voltage and current output characteristics of an inverse class F amplifier with time.

DESCRIPTION OF THE EMBODIMENTS

Figures 1A and 1B illustrate schematically an arrangement of an inverse class F amplifier according to one embodiment. Such amplifiers may be utilised in radio frequency front ends of wireless network transmitters, both in user equipment and base station applications. These amplifiers are utilised to improve overall system performance. The amplifiers are highly efficient which leads to lower power consumption, reduces battery size, minimises the amount of cooling required and reduces cost. The efficiency is achieved through operation of the amplifier in a saturation mode. However, operation in the saturation mode reduces linearity and so they are used in advanced transmitter architectures like Doherty, linear amplification using non-linear components (LINC) or envelope elimination and restoration (EER) arrangements.

As shown in Figure 4, this efficiency is achieved through the careful arrangement of the flow of voltage and current at the output of the amplifying device. In the inverse class F amplifier, the current waveform is ideally a square wave and the voltage waveform is ideally a half sine wave. If these waveforms can be achieved, the product of the two will be zero at all frequencies, except at the fundamental frequency. When this ideal is achieved, power dissipation in the amplifier becomes close to zero.

To obtain these waveforms, all impedances at the different harmonic frequencies need to be carefully controlled. The half sine wave voltage consists of fundamental and even harmonics and so the output impedance seen by the amplifying device at these frequencies needs to be affectively infinite (i.e. an open-circuit) in order to minimise current flow. However, the square wave current only consists of odd harmonics and so the output impedance seen by the amplifying device at these frequencies should be effectively zero (i.e. a closed circuit) in order to minimise voltage. To ensure optimum efficiency at the fundamental frequency, the output impedance of the amplifying device needs to match that of the load.

In practice, it is often not necessary to control every odd and even harmonic. Instead, the even harmonics are dominated by the second harmonic, whilst the odd harmonics are dominated by the third harmonic. Hence, adequate control can be achieved through controlling the impedance characteristics at these two harmonics.

Returning now to Figure 1A , the inverse class F amplifier receives a signal generated by a signal generator 20 which is to be amplified and provided to a load $R_L$. The signal to be amplified is received over a path 25 at the gate of a field effect transistor 30. The source of

the field effect transistor 30 is coupled to ground, whilst the drain is coupled to a network comprising a number of transmission line strips and stubs. As will be explained in more detail below, two of these transmission line strips or stubs are configured to have a variable length in order to be able to adjust the effective electrical length of these transmission lines to improve the characteristics of the amplifier.

Two variable length transmission $TL_1$ and $TL_2$ lines are provided between the drain of the transistor 30 and a capacitor $C_1$ providing a DC block at the output to which the load $R_L$ is connected. Between the two variable length transmission lines $TL_1$ and $TL_2$ is connected a third transmission line $TL_3$ which couples via a capacitor $C_2$ to ground. A fourth transmission line $TL_4$ is connected between the second variable length transmission line $TL_2$ and the capacitor $C_1$. The electrical length of the two variable length transmission lines $TL_1$ and $TL_2$ are determined in accordance with equations mentioned in more detail below. The third transmission line $TL_3$ has an electrical length of 90° at the fundamental frequency. The fourth transmission line $TL_4$ has an electrical length of 30° at the fundamental frequency. The fourth transmission line $TL_4$ is a stub which is left in an open-circuit configuration.

Figure 1B shows a simplified presentation of the transmission line network and also shows the output parasitic series bond wire and lead inductance $L_{OUT}$ of the field effect transistor 30 which makes it difficult to provide a good second harmonic peaking and a third harmonic short termination in a real circuit. Also shown is the output capacitance $C_{OUT}$ of the field effect transistor 30. It will be appreciated that the characteristics of the amplifier will depend of the physical length of this inductance, which is difficult to set very accurately in real hybrid or monolithic integrated circuits and so may vary from device to device. Complex conjugate load matching is achieved at the fundamental frequency, together with high impedance at the second harmonic and low impedance at the third harmonic at the device output by using two series transmission lines $TL_1$ and $TL_2$ with variable lengths (which are selected depending on the device output shunt capacitance $C_{OUT}$ and series inductance $L_{OUT}$), in combination with the quarter wave short-circuit stub $TL_3$ and the open-circuit stub $TL_4$ with an electrical length of 30°.

The following description of the behaviour of the transmission lines $TL_1$ to $TL_4$ should be read in conjunction with Figures 3A (which shows the effective impedance of a closed-circuit transmission line at different electrical lengths) and Figure 3B (which shows the effective impedance of an open-circuit transmission line at different electrical lengths). Figure 2A illustrates the effective network seen by the field effect transistor 30 at the fundamental frequency. The third transmission line $TL_3$ is in a closed-circuit configuration and, from Figure 3A, it can be seen that this presents an infinite impedance. The transmission line $TL_4$ is in open-circuit and, it can be seen from Figure 3B, presents a capacitive impedance. Hence the network seen by the transistor 30 at the fundamental frequency will be the series of the two variable transmission lines $TL_1$ and $TL_2$, together with the open-circuit capacitive stub $TL_4$, to provide impedance matching between the transistor output impedance $R_{OUT}$ and load resistance $R_L$. The electrical lengths of these two variable length transmission lines are calculated in accordance with the following equations:

$$\theta_1 = \frac{1}{2}\tan^{-1}\frac{1-(2\omega_0)^2 L_{out}C_{out}}{2Z_1\omega_0 C_{out}}$$

$$\theta_2 = \frac{\pi}{3} - \frac{1}{3}\tan^{-1}\frac{3\omega_0 L_{out}}{Z_1} - \theta_1$$

Where $C_{OUT}$ and $L_{OUT}$ are the shunt capacitance and the parasitic inductance of the transistor 30 respectively, and ωo is the fundamental or operating frequency of the received signal to be amplified.

In an ideal implementation, where $L_{OUT} = C_{OUT}$ = zero, the value of $\theta_1$ is 45° and the value of $\theta_2$ is 15°.

Figure 2B illustrates the load network seen by the field effect transistor 30 at the second harmonic frequency. At the second harmonic frequency, the transmission line $TL_3$ has an electrical length of 180° (i.e. 2x90°) and, as can be seen from Figure 3A, for a closed-circuit transmission line presents a zero impedance. Hence, due to the shorting effect of the quarter wave short-circuit stub $TL_3$, the transmission line $TL_1$ provides and open-circuit condition for the second harmonic at the transistor 30 output by forming a second-harmonic tank, together with $C_{out}$ and $L_{out}$. For example, assuming the first variable length transmission line $TL_1$ has the idealised electrical length of 45°, then, as can be seen from Figure 3A, the transmission line $TL_1$ presents an infinite impedance at 90° (i.e. 2x45°), when $C_{OUT} = L_{OUT} = 0$.

Figure 2C illustrates the load network seen by the field effect transistor 30 at the third harmonic frequency. At the third harmonic frequency, the closed-circuit transmission line $TL_3$ has an electrical length of 270° (i.e. 3x90°) and, as can be seen from Figure 3A, presents an infinite impedance. Likewise, the transmission line $TL_4$ has an electrical length of 90° (i.e. 3x30°) and, as can be seen from Figure 3B, presents a short-circuit. The resulting transmission lines $TL_1$ and $TL_2$, together with the series inductance $L_{OUT}$ then provides a short-circuit condition for the third harmonic at the field effect transistor 30 output. For example, assuming the first variable length transmission line $TL_1$ has the idealised electrical length of 45° and the second variable length transmission line $TL_2$ has the idealised electrical length of 15° then, as can be seen from Figure 3A, the transmission line $TL_1$ presents close to a zero impedance at 180° (i.e. 3x60°)

Hence, it can be seen that adjustment of the transmission lines $TL_1$ and $TL_2$ can easily provide the required open and short circuit conditions, as well as impedance matching at the fundamental frequency, depending on the actual physical length of the transistor 30 output electrodes and their associated parasitic inductance and shunt capacitance.

The mechanism used to vary the length of the transmission lines $TL_1$ and $TL_2$ may be in accordance with known techniques. For example, lengths of the transmission lines may be etched away, loops may be provided or breaks made in a so-called "ladder" arrangement.

Through this approach an efficient inverse F class amplifier may be provided which can readily be adapted to achieve high efficiencies irrespective of the tolerances of the characteristics of the field effect transistor 30 or the particular layout of the amplifier circuit itself.

It will be appreciated from Figures 3A and 3B that the required characteristics of the different transmission lines mentioned above can be achieved by utilising transmission lines of different lengths in the other open or closed circuit configurations.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

It should be appreciated by those skilled in the art that any block diagrams herein represent conceptual views of illustrative circuitry embodying the principles of the invention.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions.

**Claims**

**1.** An inverse class F amplifier, comprising:

an input (25) operable to receive a microwave frequency signal to be amplified;
on output operable to provide an amplified signal to a load ($R_L$): and
a network coupling the input with said output and operable to amplify said microwave frequency signal to generate said amplified signal, said network comprising:

an amplifying device (30); and
a load network comprising at least one variable length transmission line operable to have its length adjusted to vary its effective electrical length to provide, to said amplifying device, a first impedance at a fundamental frequency of said microwave frequency signal, a second impedance at a second harmonic frequency of said microwave frequency signal, said second impedance being higher than said first impedance and a third impedance at a third harmonic frequency of said microwave frequency signal, said third impedance being lower than said first impedance, wherein said load network comprises at least two variable length transmission lines ($TL_1$, $TL_2$) coupling said input with said output at least a first transmission line and at least a second transmission line, said at least two variable length transmission lines and said first and second transmission lines together providing said first, second and third a stub impedances one ($TL_3$) of said first and second transmission lines is a stub provided, wherein said at least two variable length transmission lines comprises a first variable length transmission line and a second variable length transmission line, said first variable length transmission line being coupled with said input and said second variable length transmission line, and said second variable length transmission line being coupled with said first variable length transmission line and said output between said two variable length transmission lines and another ($TL_4$) of said first and second transmission lines is a stub provided between said second variable length transmission line and said output, said one of said first and second transmission lines is a stub arranged in a closed-circuit configuration and has on electrical length at said fundamental frequency of around 90° and said another of said first and second transmission lines has an electrical

length at said fundamental frequency of around 30°.

2. The inverse class F amplifier of claim 1, wherein said at least two variable length transmission lines are provided in series between said input and said output.

3. The inverse class F amplifier of claim 1 or 2, wherein said another of said first and second transmission lines provided between said second variable length transmission line and said output is arranged in an open-circuit configuration.

4. The inverse class F amplifier of any one of claims 2 or 3, wherein said first variable length transmission having an adjustable length to provide a first effective electrical length calculated in accordance with the following equation:

$$\theta_1 = \frac{1}{2}\tan^{-1}\frac{1-(2\omega_0)^2 L_{out} C_{out}}{2Z_1\,\omega_0 C_{out}}$$

and said second variable length transmission having an adjustable length to provide a second effective electrical length calculated in accordance with the following equation:

$$\theta_2 = \frac{\pi}{3} - \frac{1}{3}\tan^{-1}\frac{3\omega_0 L_{out}}{Z_1} - \theta_1$$

where $\theta_1$ and $\theta_2$ are said first and second effective electrical lengths respectively, $\omega_0$ is said fundamental frequency, $L_{out}$ is an output inductance of said amplifying device, $C_{out}$ is an output capacitance of said amplifying device and $Z_1$ is a characteristic impedance of said first and second variable length transmission lines.

5. The inverse class F amplifier of claim 4, wherein when said output inductance of said amplifying device and said output capacitance of said amplifying device are around zero, said first effective electrical length comprises around 45° and said second effective electrical length comprises around 15°.

6. The inverse class F amplifier of any preceding claim, wherein said first impedance matches an impedance of said load at said fundamental frequency.

7. The inverse class F amplifier of any preceding claim, wherein said second impedance is effectively infinite, presenting on open circuit to said amplifying device at said second harmonic frequency.

8. The inverse class F amplifier of any preceding claim, wherein said third impedance is effectively zero, presenting a closed circuit to said amplifying device at said third harmonic frequency.

9. A method of calibrating an inverse class F amplifier comprising an input (25) operable to receive a microwave frequency signal to be amplified, an output operable to provide an amplified signal to a load ($R_L$), and a network coupling the input with said output and operable to amplify said microwave frequency signal to generate said amplified signal, said network comprising an amplifying device (30) and a load network comprising at least one variable length transmission line, said method comprising the step of:

adjusting a length of said at least one variable length transmission line to vary its effective electrical length to provide, to said amplifying device, a first impedance at a fundamental frequency of said microwave frequency signal, a second impedance at a second harmonic frequency of said microwave frequency signal, said second impedance being higher than said first impedance and a third impedance at a third harmonic frequency of said microwave frequency signal, said third impedance being lower than said first impedance, wherein said load network comprises at least two variable length transmission lines ($TL_1$, $TL_2$) coupling said input with said output, at least a first transmission line and at least a second transmission line, said at least two variable length transmission lines and said first and second transmission lines together providing said first, second and third impedances a stub, one ($TL_3$) of said first and second transmission , wherein said at least two variable length transmission lines comprises a first variable length transmission line and a second variable length transmission line, said first variable length transmission line being coupled with said input and said second variable length transmission line, and said second variable length transmission line being coupled with said first variable length transmission line and said output lines is a stub provided between said two variable length transmission lines and another [$TL_4$) of said first and second transmission lines is a stub provided between said second second variable length transmission line and said output, said one of said first and second transmission lines is a stub arranged in a closed-circuit configuration and has an electrical length at said fundamental frequency of around 90° and said another of said first and second transmission lines has an electrical length at said fundamental frequency of around 30°.

**Patentansprüche**

1. Verstärker mit inversem Klasse F-Betrieb, umfassend:

   Einen Eingang (25), der betreibbar ist, um ein zu verstärkendes Mikrowellenfrequenzsignal zu empfangen;
   einen Ausgang, der betreibbar ist, um ein verstärktes Signal an eine Last ($R_L$) bereitzustellen, und
   ein Netzwerk, welches den Eingang mit dem besagten Ausgang koppelt und
   betreibbar ist, um das besagte Mikrowellenfrequenzsignal zu verstärken, um das besagte verstärkte Signal zu erzeugen, wobei das besagte Netzwerk umfasst:

   Eine Verstärkervorrichtung (30); und
   ein Lastnetzwerk, welches mindestens eine Übertragungsleitung variabler Länge umfasst und betreibbar ist, um ihre Länge anzupassen, damit ihre effektive elektrische Länge variiert, um eine erste Impedanz bei einer Grundfrequenz des besagten Mikrowellenfrequenzsignals, eine zweite Impedanz bei einer zweiten Oberschwingungsfrequenz des besagten Mikrowellenfrequenzsignals, wobei die besagte zweite Impedanz höher als die besagte erste Impedanz ist, und eine dritte Impedanz bei einer dritten Oberschwingungsfrequenz des besagten Mikrowellenfrequenzsignals, wobei die dritte Impedanz niedriger als die besagte erste Impedanz ist, an die besagte Verstärkervorrichtung bereitzustellen, wobei das besagte Lastnetzwerk mindestens zwei Übertragungsleitungen ($TL_1$, $TL_2$) variabler Länge, welche den besagten Eingang mit dem besagten Ausgang koppeln, mindestens eine erste Übertragungsleitung und mindestens eine zweite Übertragungsleitung umfasst, wobei die besagten mindestens zwei Übertragungsleitungen variabler Länge und die besagte erste und die besagte zweite Übertragungsleitung zusammen die besagte erste, die besagte zweite und die besagte dritte Impedanz bereitstellen, wobei die besagten mindestens zwei Übertragungsleitungen variabler Länge eine erste Übertragungsleitung variabler Länge und eine zweite Übertragungsleitung variabler Länge umfassen, wobei die besagte erste Übertragungsleitung variabler Länge mit dem besagten Eingang und der besagten zweiten Übertragungsleitung variabler Länge gekoppelt ist, und wobei die besagte zweite Übertragungsleitung variabler Länge mit der besagten ersten Übertragungsleitung variabler Länge und dem besagten Ausgang gekoppelt ist, wobei eine ($TL_3$) der besagten ersten und zweiten Übertragungsleitungen eine zwischen den besagten zwei Übertragungsleitungen variabler Länge bereitgestellte Stichleitung ist, und eine anderen ($TL_4$) der besagten ersten und zweiten Übertragungsleitungen eine zwischen der besagten zweiten Übertragungsleitung variabler Länge und dem besagten Ausgang bereitgestellte Stichleitung ist, wobei die besagte eine der besagten ersten und zweiten Übertragungsleitungen eine in geschlossenem Kreislauf konfigurierte Stichleitung ist und eine elektrische Länge bei der besagten Grundfrequenz von etwa 90° aufweist, und die besagte andere der besagten ersten und zweiten Übertragungsleitungen eine elektrische Länge bei der besagten Grundfrequenz von rund 30° aufweist.

2. Verstärker mit inversem Klasse F-Betrieb nach Anspruch 1, wobei die besagten mindestens zwei Übertragungsleitungen variabler Länge in Reihe zwischen dem besagten Eingang und dem besagten Ausgang bereitgestellt werden.

3. Verstärker mit inversem Klasse F-Betrieb nach Anspruch 1 oder 2, wobei die besagte zwischen der besagten zweiten Übertragungsleitung variabler Länge und dem besagten Ausgang bereitgestellte andere der besagten ersten und zweiten Übertragungsleitungen in offenem Kreislauf konfiguriert ist.

4. Verstärker mit inversem Klasse F-Betrieb nach Anspruch 2 oder 3, wobei die besagte erste Übertragungsleitung variabler Länge eine einstellbare Länge hat, um eine gemäß der folgenden Gleichung berechnete erste effektive elektrische Länge bereitzustellen:

$$\theta_1 = \frac{1}{2}\tan^{-1}\frac{1-(2\omega_0)^2 L_{out} C_{out}}{2 Z_1 \omega_0 C_{out}}$$

   und wobei die besagte zweite Übertragung variabler Länge eine einstellbare Länge hat, um eine gemäß der folgenden Gleichung berechnete zweite effektive elektrische Länge bereitzustellen:

$$\theta_2 = \frac{\pi}{3} - \frac{1}{3}\tan^{-1}\frac{3\omega_0 L_{out}}{Z_1} - \theta_1$$

wobei $\theta_1$ und $\theta_2$ jeweils die besagte erste bzw. zweite effektive elektrische Länge darstellen, $\omega_0$ die besagte Grundfrequenz darstellt, $L_{out}$ eine Ausgangsinduktivität der besagten Verstärkervorrichtung darstellt, $C_{out}$ eine Ausgangskapazität der besagten Verstärkervorrichtung darstellt, und $Z_1$ eine charakteristische Impedanz der besagten ersten und zweiten Übertragungsleitungen variabler Länge darstellt.

**5.** Verstärker mit inversem Klasse F-Betrieb nach Anspruch 4, wobei die besagte Ausgangsinduktivität der besagten Verstärkervorrichtung und die besagte Ausgangskapazität der besagten Verstärkervorrichtung etwa Null betragen, wobei die besagte erste effektive elektrische Länge etwa 45° umfasst und die besagte zweite effektive elektrische Länge etwa 15° umfasst.

**6.** Verstärker mit inversem Klasse F-Betrieb nach einem beliebigen der vorstehenden Ansprüche, wobei die besagte erste Impedanz einer Impedanz der besagten Last bei der besagten Grundfrequenz entspricht.

**7.** Verstärker mit inversem Klasse F-Betrieb nach einem beliebigen der vorstehenden Ansprüche, wobei die besagte zweite Impedanz effektiv unendlich ist, mit einem offenen Kreislauf zu der besagten Verstärkervorrichtung bei der besagten zweiten Oberschwingungsfrequenz.

**8.** Verstärker mit inversem Klasse F-Betrieb nach einem beliebigen der vorstehenden Ansprüche, wobei die besagte dritte Impedanz effektiv Null ist, mit einem geschlossenen Kreislauf zu der besagten Verstärkervorrichtung bei der besagten dritten Oberschwingungsfrequenz.

**9.** Verfahren zur Kalibrierung eines Verstärkers mit inversem Klasse F-Betrieb mit einem Eingang (25), der betreibbar ist, um ein zu verstärkendes Mikrowellenfrequenzsignal zu empfangen, einem Ausgang, der betreibbar ist, um ein verstärktes Signal an eine Last ($R_L$) bereitzustellen, und einem Netzwerk, welches den Eingang mit dem besagten Ausgang koppelt und betreibbar ist, um das besagte Mikrowellenfrequenzsignal zu verstärken, um das besagte verstärkte Signal zu erzeugen, wobei das besagte Netzwerk eine Verstärkervorrichtung (30) und ein Lastnetzwerk mit mindestens einer Übertragungsleitung variabler Länge umfasst, wobei das besagte Verfahren den folgenden Schritt umfasst:

Anpassen einer Länge der besagten mindestens einen Übertragungsleitung variabler Länge, um ihre effektive elektrische Länge zu variieren, um eine erste Impedanz bei einer Grundfrequenz des besagten Mikrowellenfrequenzsignals, eine zweite Impedanz bei einer zweiten Oberschwingungsfrequenz des besagten Mikrowellenfrequenzsignals, wobei die besagte zweite Impedanz höher als die besagte erste Impedanz ist, und eine dritte Impedanz bei einer dritten Oberschwingungsfrequenz des besagten Mikrowellenfrequenzsignals, wobei die dritte Impedanz niedriger als die besagte erste Impedanz ist, an die besagte Verstärkervorrichtung bereitzustellen, wobei das besagte Lastnetzwerk mindestens zwei Übertragungsleitungen ($TL_1$, $TL_2$) variabler Länge, welche den besagten Eingang mit dem besagten Ausgang koppeln, mindestens eine erste Übertragungsleitung und mindestens eine zweite Übertragungsleitung umfasst, wobei die besagten mindestens zwei Übertragungsleitungen variabler Länge und die besagte erste und die besagte zweite Übertragungsleitung zusammen die besagte erste, die besagte zweite und die besagte dritte Impedanz bereitstellen, wobei die besagten mindestens zwei Übertragungsleitungen variabler Länge eine erste Übertragungsleitung variabler Länge und eine zweite Übertragungsleitung variabler Länge umfassen, wobei die besagte erste Übertragungsleitung variabler Länge mit dem besagten Eingang und der besagten zweiten Übertragungsleitung variabler Länge gekoppelt ist, und wobei die besagte zweite Übertragungsleitung variabler Länge mit der besagten ersten Übertragungsleitung variabler Länge und dem besagten Ausgang gekoppelt ist, wobei eine ($TL_3$) der besagten ersten und zweiten Übertragungsleitungen eine zwischen den besagten zwei Übertragungsleitungen variabler Länge bereitgestellte Stichleitung ist, und eine anderen ($TL_4$) der besagten ersten und zweiten Übertragungsleitungen eine zwischen der besagten zweiten Übertragungsleitung variabler Länge und dem besagten Ausgang bereitgestellte Stichleitung ist, wobei die besagte eine der besagten ersten und zweiten Übertragungsleitungen eine in geschlossenem Kreislauf konfigurierte Stichleitung ist und eine elektrische Länge bei der besagten Grundfrequenz von etwa 90° aufweist, und die besagte andere der besagten ersten und zweiten Übertragungsleitungen eine elektrische Länge bei der besagten Grundfrequenz von rund 30° aufweist

## Revendications

**1.** Amplificateur de classe F inverse, comprenant :

une entrée (25) permettant de recevoir un signal hyperfréquence à amplifier ;
une sortie permettant de fournir un signal amplifié à une charge ($R_L$) ; et
un réseau connectant l'entrée à ladite sortie et permettant d'amplifier ledit signal hyperfréquence pour générer ledit signal amplifié, ledit réseau comprenant :

un dispositif d'amplification (30) ; et
un réseau de charge comprenant au moins une ligne de transmission de longueur variable permettant d'ajuster sa longueur pour modifier sa longueur électrique effective afin de fournir, audit dispositif d'amplification, une première impédance à une fréquence fondamentale dudit signal hyperfréquence, une deuxième impédance à une deuxième fréquence harmonique dudit signal hyperfréquence, ladite deuxième impédance étant supérieure à ladite première impédance et une troisième impédance à une troisième fréquence harmonique dudit signal hyperfréquence, ladite troisième impédance étant inférieure à ladite première impédance, dans lequel ledit réseau de charge comprend au moins deux lignes de transmission de longueur variable ($TL_1$, $TL_2$) connectant ladite entrée à ladite sortie, au moins une première ligne de transmission et au moins une deuxième ligne de transmission, lesdites au moins deux lignes de transmission de longueur variable et lesdites première et deuxième lignes de transmission fournissant ensemble lesdites première, deuxième et troisième impédances, dans lequel lesdites au moins deux lignes de transmission de longueur variable comprennent une première ligne de transmission de longueur variable et une deuxième ligne de transmission de longueur variable, ladite première ligne de transmission de longueur variable étant connectée à ladite entrée et à ladite deuxième ligne de transmission de longueur variable, et ladite deuxième ligne de transmission de longueur variable étant connectée à ladite première ligne de transmission de longueur variable et à ladite sortie, une ($TL_3$) desdites première et deuxième lignes de transmission est un tronçon de ligne disposé entre lesdites deux lignes de transmission de longueur variable et une autre ($TL_4$) parmi lesdites première et deuxième lignes de transmission est un tronçon de ligne disposé entre ladite deuxième ligne de transmission de longueur variable et ladite sortie, ladite une parmi lesdites première et deuxième lignes de transmission est un tronçon de ligne agencé dans une configuration de circuit fermé et présente une longueur électrique à ladite fréquence fondamentale d'environ 90° et ladite autre parmi lesdites première et deuxième lignes de transmission présente une longueur électrique à ladite fréquence fondamentale d'environ 30°.

**2.** Amplificateur de classe F inverse selon la revendication 1, dans lequel lesdites au moins deux lignes de transmission de longueur variable sont disposées en série entre ladite entrée et ladite sortie.

**3.** Amplificateur de classe F inverse selon la revendication 1 ou 2, dans lequel ladite autre parmi lesdites première et deuxième lignes de transmission disposées entre ladite deuxième ligne de transmission de longueur variable et ladite sortie est agencée dans une configuration de circuit ouvert.

**4.** Amplificateur de classe F inverse selon l'une quelconque des revendications 2 et 3, dans lequel ladite première transmission de longueur variable présente une longueur ajustable pour fournir une première longueur électrique effective calculée conformément à l'équation suivante :

$$\theta_1 = \frac{1}{2}\tan^{-1}\frac{1-(2\omega_0)^2 L_{out} C_{out}}{2 Z_1 \omega_0 C_{out}}$$

et ladite deuxième transmission de longueur variable présente une longueur ajustable pour fournir une deuxième longueur électrique effective calculée conformément à l'équation suivante :

$$\theta_2 = \frac{\pi}{3} - \frac{1}{3}\tan^{-1}\frac{3\omega_0 L_{out}}{Z_1} - \theta_1$$

dans laquelle $\theta_1$ et $\theta_2$ sont respectivement lesdites première et deuxième longueurs électriques effectives, $\omega_0$ est ladite fréquence fondamentale, $L_{out}$ est une inductance de sortie dudit dispositif d'amplification, $C_{out}$ est une capacité de sortie dudit dispositif d'amplification et $Z_1$ est une impédance caractéristique desdites première et deuxième lignes de transmission de longueur variable.

**5.** Amplificateur de classe F inverse selon la revendication 4, dans lequel lorsque ladite inductance de sortie dudit dispositif d'amplification et lorsque ladite capacité de sortie dudit dispositif d'amplification sont environ égales à zéro, ladite première longueur électrique effective est environ de 45° et ladite deuxième longueur électrique effective est environ de 15°.

**6.** Amplificateur de classe F inverse selon l'une quelconque des revendications précédentes, dans lequel ladite première impédance correspond à une impédance de ladite charge à ladite fréquence fondamentale.

**7.** Amplificateur de classe F inverse selon l'une quelconque des revendications précédentes, dans lequel ladite deuxième impédance est effectivement infinie, présentant un circuit ouvert audit dispositif d'amplification à ladite deuxième fréquence harmonique.

**8.** Amplificateur de classe F inverse selon l'une quelconque des revendications précédentes, dans lequel ladite troisième impédance est effectivement égale à zéro, présentant un circuit fermé audit dispositif d'amplification à ladite troisième fréquence harmonique.

**9.** Procédé d'étalonnage d'un amplificateur de classe F inverse comprenant une entrée (25) permettant de recevoir un signal hyperfréquence à amplifier, une sortie permettant de fournir un signal amplifié à une charge ($R_L$), et un réseau connectant l'entrée à ladite sortie et permettant d'amplifier ledit signal hyperfréquence afin de générer ledit signal amplifié, ledit réseau comprenant un dispositif d'amplification (30) et un réseau de charge comprenant au moins une ligne de transmission de longueur variable, ledit procédé comprenant l'étape suivante :

ajuster une longueur de ladite au moins une ligne de transmission de longueur variable pour modifier sa longueur électrique effective afin de fournir, audit dispositif d'amplification, une première impédance à une fréquence fondamentale dudit signal hyperfréquence, une deuxième impédance à une deuxième fréquence harmonique dudit signal hyperfréquence, ladite deuxième impédance étant supérieure à ladite première impédance et une troisième impédance à une troisième fréquence harmonique dudit signal hyperfréquence, ladite troisième impédance étant inférieure à ladite première impédance, dans lequel ledit réseau de charge comprend au moins deux lignes de transmission de longueur variable ($TL_1$, $TL_2$) connectant ladite entrée à ladite sortie, au moins une première ligne de transmission et au moins une deuxième ligne de transmission, lesdites au moins deux lignes de transmission de longueur variable et lesdites première et deuxième lignes de transmission fournissant ensemble lesdites première, deuxième et troisième impédances, dans lequel lesdites au moins deux lignes de transmission de longueur variable comprennent une première ligne de transmission de longueur variable et une deuxième ligne de transmission de longueur variable, ladite première ligne de transmission de longueur variable étant connectée à ladite entrée et à ladite deuxième ligne de transmission de longueur variable, et ladite deuxième ligne de transmission de longueur variable étant connectée à ladite première ligne de transmission de longueur variable et à ladite sortie, une ($TL_3$) desdites première et deuxième lignes de transmission est un tronçon de ligne disposé entre lesdites deux lignes de transmission de longueur variable et une autre ($TL_4$) parmi lesdites première et deuxième lignes de transmission est un tronçon de ligne disposé entre ladite deuxième ligne de transmission de longueur variable et ladite sortie, ladite une parmi lesdites première et deuxième lignes de transmission est un tronçon de ligne agencé dans une configuration de circuit fermé et présente une longueur électrique à ladite fréquence fondamentale d'environ 90° et ladite autre parmi lesdites première et deuxième lignes de transmission présente une longueur électrique à ladite fréquence fondamentale d'environ 30°.

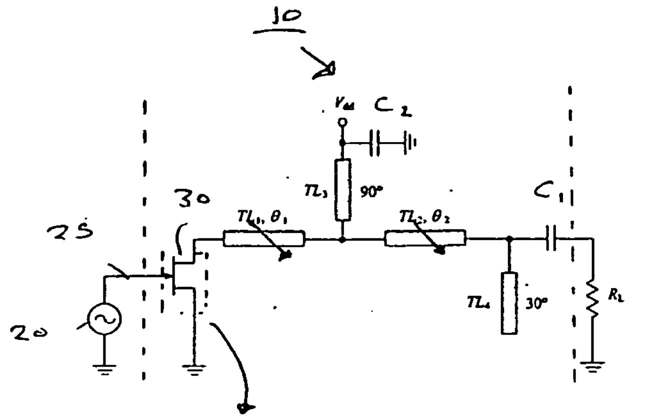


FIG 1A

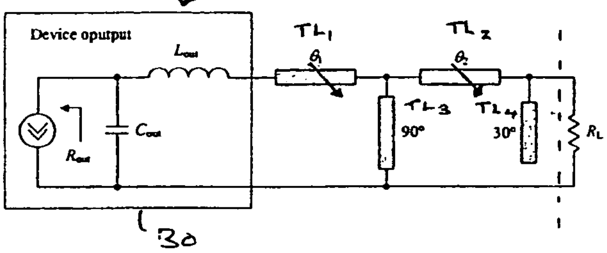


FIG 1B

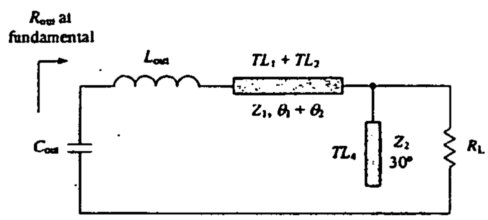


FIG 2A

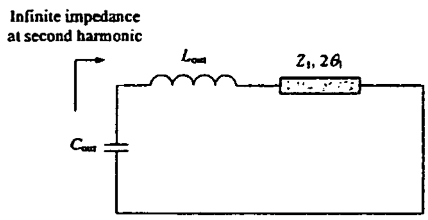


FIG 2B

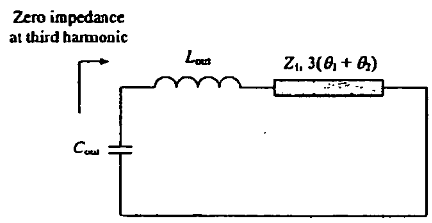


FIG 2C

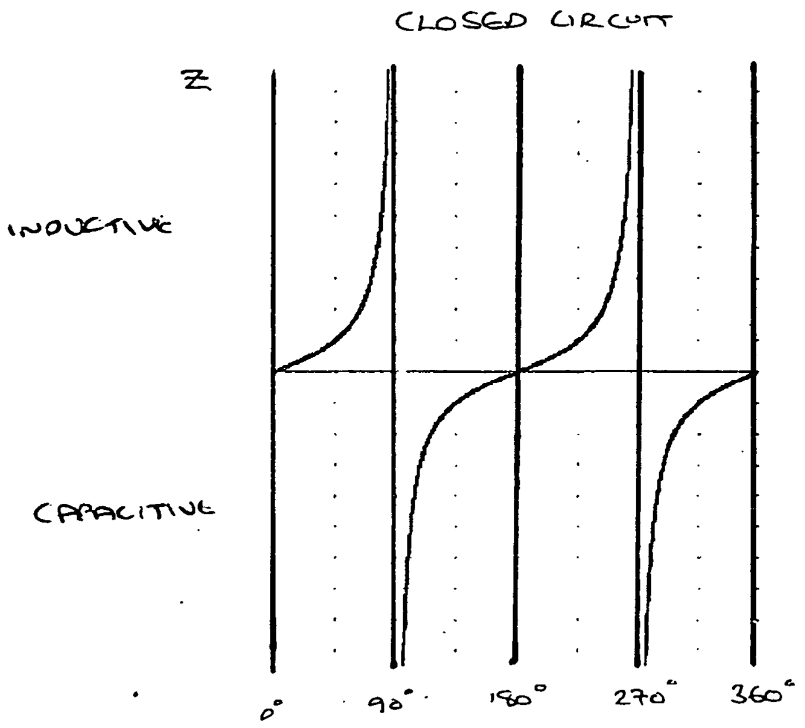
CLOSED CIRCUIT
Z
INDUCTIVE
CAPACITIVE
0°
90°
180°
270°
360°

FIG 3A

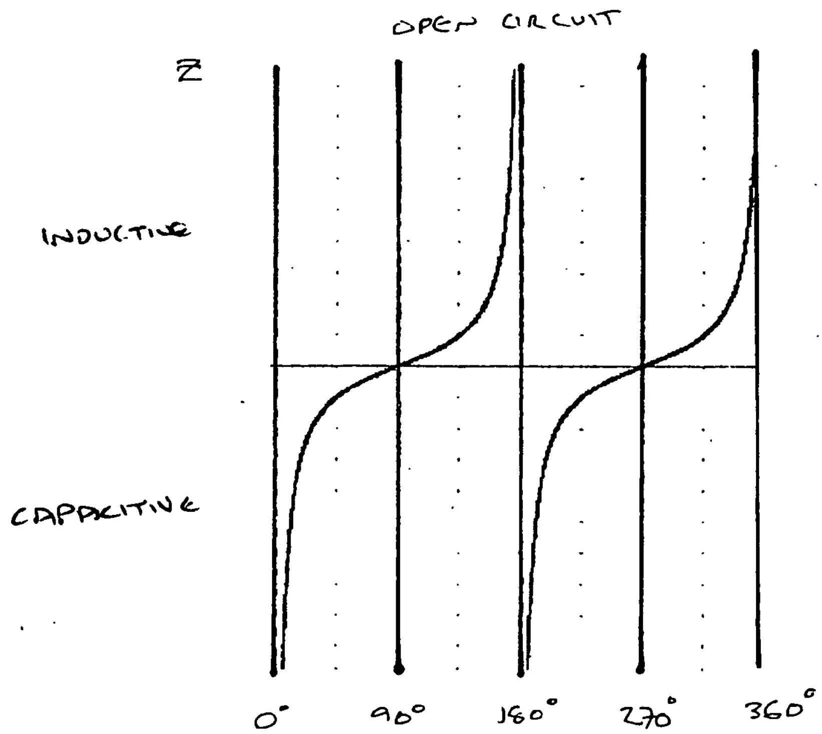
OPEN CIRCUIT
Z
INDUCTIVE
CAPACITIVE
0°
90°
180°
270°
360°

FIG 3B

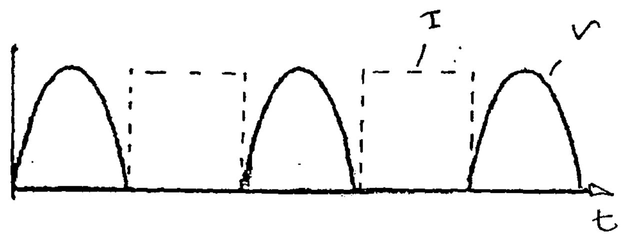


FIG 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2008191801 A


### Non-patent literature cited in the description


- **GOTO et al.** Efficiency enhancement of doherty amplifier with combination of class-F and inverse class-F schemes for S-band base station application. *MICROWAVE SYMPOSIUM DIGEST 2004, IEEE MTT-S INTERNATIONAL FORT WORTH, TX, USA,* 06 June 2004, vol. 2, ISBN 978-0-7803-8331-9, 839-842